# EUROPÄISCHE PATENTSCHRIFT

(11) **EP 1 208 645 B1**
(45) Veröffentlichungstag und Bekanntmachung des Hinweises auf die Patenterteilung: **26.10.2005**
(21) Anmeldenummer: 01956405.3
(22) Anmeldetag: 28.07.2001
(51) Int. Cl.: H03K 3/354, G01R 33/02, G01R 19/20

(54) **SCHALTUNGSANORDNUNG ZUR ERZEUGUNG VON RECHTECKIMPULSEN**
CIRCUIT CONFIGURATION FOR GENERATING SQUARE WAVE PULSES
CIRCUIT POUR PRODUIRE DES IMPULSIONS CARREES

(30) Priorität: 12.08.2000 DE 10039473
(43) Veröffentlichungstag der Anmeldung: 29.05.2002
(73) Patentinhaber: ROBERT BOSCH GMBH, 70442 Stuttgart (DE)
(72) Erfinder: FIEDLER, Gerhard, 72666 Neckartailfingen (DE); HALLER, Volker, 72810 Gomaringen (DE); WENGER, Christoph, 70825 Korntal-Muenchingen (DE); NASSWETTER, Guenter, 72810 Gomaringen (DE)
(86) Internationale Anmeldenummer: PCT/DE2001/002866
(87) Internationale Veröffentlichungsnummer: WO 2002/015399

(56) Entgegenhaltungen:
- EP-A- 0 261 707
- DE-A- 19 844 729
- US-A- 4 298 838
- US-A- 4 347 469
- US-A- 4 851 775
- US-A- 5 552 979
- US-A- 5 757 184

## Beschreibung

### Stand der Technik

Die Erfindung betrifft eine Schaltungsanordnung zur Erzeugung von Rechteckimpulsen, mit einem flankengetriggerten Flip-Flop und wenigstens einem Komparator, dessen Ausgang mit dem Triggereingang des Flip-Flops verbunden ist, sowie einem Energiespeicherelement, welches in Abhängigkeit des Schaltzustandes des Flip-Flops wechselseitig aufgeladen wird, wobei in Reihe mit dem Energiespeicherelement wenigstens ein Schaltschwellenwiderstand geschaltet ist, an welchem eine vom durch das Energiespeicherelement fließenden Strom erzeugte Spannung abfällt, welche auf den Signaleingang des Komparators gegeben wird.

Es ist bekannt, eine derartige Schaltungsanordnung zur Erzeugung von Rechteckimpulsen zu verwenden. Die bekannte Schaltung wird beispielsweise zur Messung der Feldstärke eines Magnetfeldes verwendet. Dabei wird eine Magnetfeldsonde, die als Induktivität ausgebildet ist und das Energiespeicherelement darstellt, in das zu messende Magnetfeld eingebracht. Die Magnetfeldsonde ist so ausgebildet, daß sie durch das zu messende Magnetfeld und das durch den Strom erzeugte Magnetfeld in die Sättigung gebracht wird. Solange auf die Magnetfeldsonde kein äußeres Magnetfeld einwirkt, das heißt, das zu messende Magnetfeld Null ist, hat die Magnetfeldsonde in Bezug auf einen durch sie hindurchfließenden elektrischen Strom ein von der Richtung des Stroms unabhängiges elektrisches Verhalten. Bei den von der Schaltungsanordnung erzeugten Rechteckimpulsen stellt sich somit ein Tastverhältnis von 1 zu 1 ein.

Wirkt auf die Magnetfeldsonde ein äußeres Magnetfeld ein, das heißt, ist das zu messende Magnetfeld nicht mehr Null, gelangt die Magnetfeldsonde in einer Richtung früher in die Sättigung, als in der anderen. Bezüglich eines durch sie hindurchfließenden elektrischen Stromes ist ihr Verhalten daher nicht mehr von der Richtung des elektrischen Stromes unabhängig. Hierdurch ändert sich das Tastverhältnis der Rechteckimpulse. Das Tastverhältnis der Rechteckimpulse stellt somit ein Maß für das auf die Magnetfeldsonde einwirkende magnetische Feld dar.

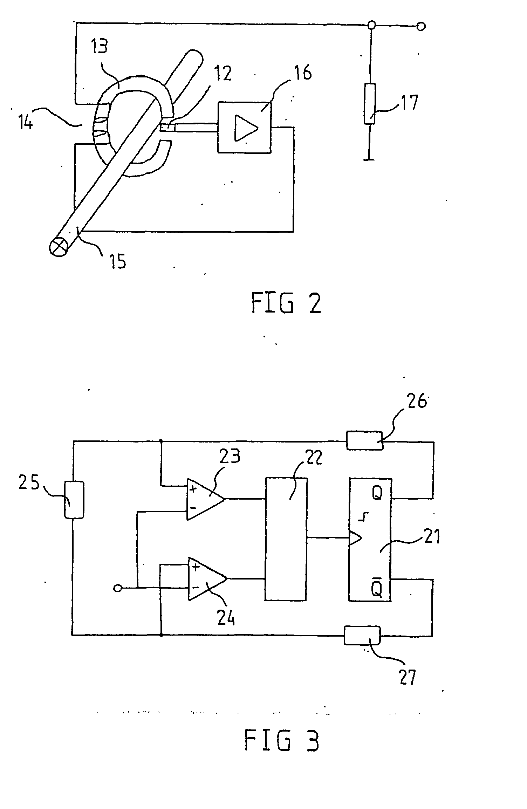

Eine bekannte Schaltungsanordnung ist in Figur 3 dargestellt. Bei der bekannten Schaltungsanordnung sind zwei Komparatoren vorgesehen, deren Ausgänge auf ein UND-Gatter gehen, dessen Ausgang mit dem Triggereingang des Flip-Flops verbunden ist. Die Signaleingänge der Komparatoren sind jeweils mit einem anderen Ende des Energiespeichers, das heißt der Magnetfeldsonde, verbunden. Der Energiespeicher ist zwischen die beiden Ausgänge des Flip-Flops geschaltet. Somit fließt je nach Stellung des Flip-Flops in unterschiedlicher Richtung Strom durch den Energiespeicher. Zwischen den Ausgängen des Flip-Flops und dem Energiespeicher sind jeweils Schaltschwellenwiderstände geschaltet. Die Verbindungsstellen der Schaltschwellenwiderstände und dem Energiespeicher sind jeweils mit dem Signaleingang eines Komparators verbunden. Die beiden Referenzeingänge der Komparatoren sind miteinander verbunden, so daß an beiden Komparatoren dieselbe Referenzspannung anliegt.

Nach einem Umschalten des Flip-Flops liegt an dem Ausgang des Flip-Flops, an dem keine Ausgangsspannung anlag, nunmehr Ausgangsspannung an und an dem anderen Ausgang nicht mehr. Durch die in der Spule gespeicherte Energie wird der ursprüngliche Stromfluß jedoch aufrechterhalten. Hierdurch sinkt das Potential am Signaleingang des betreffenden Komparators unter die Schaltschwelle. Dies hat zur Folge, daß die Spannung am Ausgang des betreffenden Komparators Null wird. Hierdurch wird auch der Ausgang des UND-Gatters Null. so daß die Spannung am Signaleingang des betreffenden Komparators wieder die Schaltschwelle erreicht, wodurch der Komparator wieder ein Ausgangssignal abgibt, und das UND-Gatter durchschaltet. Durch die beim Schalten des UND-Gatters entstehende Flanke wird das Flip-Flop wieder getriggert, so daß es erneut umschaltet, und sich der soeben beschriebene Vorgang wiederholt. Die Schaltung ist so dimensioniert, daß sie mit einer Frequenz von etwa 350 Kilohertz schwingt.

Die bekannte Schaltung hat jedoch den Nachteil, daß sich die Toleranzen der Schaltschwellenwiderstände sowie die Toleranzen der Schaltschwellen der Komparatoren auf das Tastverhältnis auswirken. Darüber hinaus wirken sich unterschiedliche Verzögerungszeiten der Komparatoren nachteilig auf eine Symmetrie der Schaltungsanordnung aus. Auch wirkt sich die Laufzeit des UND-Gatters nachteilig auf die mit der Schaltung erreichte Auflösung aus. Darüber hinaus entstehen durch die Verwendung eines UND-Gatters weitere Kosten.

Es ist Aufgabe der Erfindung, eine eingangs genannte Schaltungsanordnung derart auszubilden, daß der Einfluß der Toleranz der Bauelemente reduziert wird.

Die Lösung dieser Aufgabe ergibt sich aus den Merkmalen des kennzeichnenden Teils des Anspruchs 1. Vorteilhafte Weiterbildungen der Erfindung ergeben sich aus den Unteransprüchen.

### Vorteile der Erfindung

Gemäß der Erfindung ist eine Schaltungsanordnung zur Erzeugung von Rechteckimpulsen, mit einem flankengetriggerten Flip-Flop und wenigstens einem Komparator, dessen Ausgang mit dem Triggereingang des Flip-Flops verbunden ist, sowie einem Energiespeicherelement, welches in Abhängigkeit des Schaltzustandes des Flip-Flops wechselseitig aufgeladen wird, wobei in Reihe mit dem Energiespeicherelement wenigstens ein Schaltschwellenwiderstand geschaltet ist, an welchem eine vom durch das Energiespeicherelement fließenden Strom erzeugte Spannung abfällt, welche auf den Signaleingang des Komparators gegeben wird, dadurch gekennzeichnet, daß das Energiespeicherelement im Querzweig einer Brücke angeordnet ist, in deren vier Brückenabschnitten jeweils ein Schalter angeordnet ist, wobei die Schalter jeweils paarweise überkreuz von dem Flip-Flop geschaltet werden, so daß der Stromfluß im Querzweig umkehrbar ist, und daß die Brücke mit dem Schaltschwellenwiderstand in Reihe geschaltet ist, wobei die Verbindungsstelle der Brücke mit dem Schaltschwellenwiderstand mit dem Signaleingang des Komparators verbunden ist.

Durch die erfindungsgemäße Anordnung wird in vorteilhafter Weise vermieden, daß zwei Schaltschwellenwiderstände erforderlich sind. Hierdurch reduziert sich zum einen der benötigte Platz, und zum anderen werden durch die Verwendung nur eines Schaltschwellenwiderstands Asymmetrien vermieden. Denn dadurch, daß der durch den Energiespeicher fließende Strom immer durch denselben Schaltschwellenwiderstand fließt, wirkt sich die Toleranz des Schaltschwellenwiderstands in beiden Schaltzuständen des Flip-Flops gleich aus.

Dasselbe gilt auch für eine Toleranz des Komparators. Da nur ein Komparator verwendet wird, wirken sich Toleranzen bezüglich der Schaltschwelle und der Durchlaufzeit in beiden Schaltzuständen des Flip-Flops gleich aus. Des weiteren wird durch die Verwendung nur eines Komparators Platz und Kosten gespart.

Da in der erfindungsgemäßen Schaltungsanordnung kein UND-Gatter mehr erforderlich ist, können sich hierdurch bedingte Laufzeiten nicht auswirken. Ebenso ergibt sich in vorteilhafter Weise durch den Wegfall des UND-Gatters eine Platzeinsparung.

Als besonders vorteilhaft hat sich eine Ausführungsform der Erfindung herausgestellt, bei der das Energiespeicherelement eine Induktivität ist. Denn dadurch, daß das Energiespeicherelement eine Induktivität ist, läßt es sich als Magnetfeldsonde ausbilden, wie dies bei einer weiteren besonderen Ausführungsform der Erfindung vorgesehen ist. Bei der Ausbildung der Induktivität als Magnetfeldsonde läßt sich die erfindungsgemäße Schaltungsanordnung in besonders vorteilhafter Weise zur Messung eines Magnetfeldes verwenden.

Besonders vorteilhaft ist es, wenn die Magnetfeldsonde zur Erfassung des Magnetfeldes eines Kerns eines Kompensationsstromsensors dient, wie dies bei einer weiteren besonderen Ausführungsform der Erfindung vorgesehen ist. Durch die Verwendung der erfindungsgemäßen Schaltungsanordnung in einem Kompensationsstromsensor, läßt sich auf einfache Weise die Genauigkeit des Kompensationsstromsensors verbessern.

In einer vorteilhaften Ausgestaltung der Erfindung ist der der Komparator als Digital-Gatter ausgebildet ist. Hierdurch läßt sich die Schaltung sehr preiswert herstellen. Als Digital-Gatter könnte beispielsweise ein UND-Gatter verwendet werden. Es hat sich aber auch als vorteilhaft erwiesen einen Analog-Komparator einzusetzen, der als Ausgangssignale Digitalsignale liefert, die einfach weiterverarbeitbar sind.

Bei einer weiteren besonderen Ausführungsform der Erfindung ist in vorteilhafter Weise vorgesehen, die Schalter als MOS-FET auszubilden, von denen zwei direkt und zwei über Inverter von den Ausgängen des Flip-Flops angesteuert werden. Durch die Ausbildung der Schalter als MOS-FET läßt sich die erfindungsgemäße Schaltungsanordnung auf einfache Weise realisieren. Darüber hinaus vereinfacht sich die Ansteuerung der Schalter. Des weiteren können die Schalter sehr präzise angesteuert werden.

Darüber hinaus hat sich herausgestellt, daß es besonders vorteilhaft ist, wenn im Querzweig der Brücke in Reihe mit dem Energiespeicherelement ein Vorwiderstand geschaltet ist. Durch den Vorwiderstand läßt sich auf einfache Weise die Empfindlichkeit der Schaltungsanordnung einstellen.

Weitere Einzelheiten, Merkmale und Vorteile der vorliegenden Erfindung ergeben sich aus der nachfolgenden Beschreibung eines besonderen Ausführungsbeispiels unter Bezugnahme auf die Zeichnung.

### Zeichnung

Es zeigt: Fig. 1 eine Ausführungsform der erfindungsgemäßen Schaltungsanordnung in schematischer Darstellung, Fig. 2 einen Kompensationsstromsensor in schematischer Darstellung und Fig. 3 eine Schaltungsanordnung nach dem Stand der Technik in schematischer Darstellung.

### Beschreibung der Ausführungsbeispiele

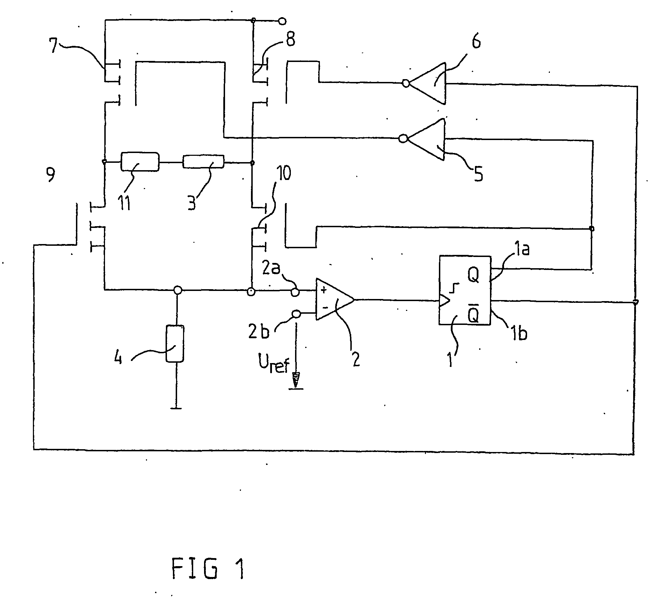

Wie Figur 1 entnommen werden kann, ist im Querzweig einer Brücke eine Spule 3 sowie ein mit ihr in Reihe geschalteter Vorwiderstand 11 angeordnet. In den vier Brückenabschnitten der Brücke ist jeweils ein als MOS-FET ausgebildeter Schalter 7, 8, 9, 10 angeordnet. Der in einem Teil der Brücke angeordnete erste Schalter 7 und der zweite Schalter 8 sind als P-Kanal MOS-FET ausgebildet und mit der Betriebsspannung V_{cc} verbunden. Der im anderen Teil der Brücke angeordnete dritte Schalter 9 und der vierte Schalter 10 sind als N-Kanal MOS-FET ausgebildet und mit einem Schaltschwellenwiderstand 4 verbunden. Das andere Ende des Schaltschwellenwiderstands 4 ist mit Masse verbunden.

Die Verbindungsstelle zwischen den N-Kanal MOS-FET 9, 10 und dem Schaltschwellenwiderstand 4 ist mit dem Signaleingang 2a eines Komparators 2 verbunden. Am Referenzeingang 2b des Komparators 2 liegt eine Referenzspannung U_{ref} an. Der Ausgang des Komparators 2 ist mit dem Triggereingang eines flankengetriggerten Flip-Flops 1 verbunden. Der nicht invertierende Ausgang 1a des Flip-Flops 1 ist über einen ersten Inverter 5 mit dem Gate des ersten P-Kanal MOS-FET 7 verbunden, sowie direkt mit dem Gate des in der Brücke überkreuz angeordneten vierten N-Kanal MOS-FET 10 verbunden. Der invertierende Ausgang 1b des Flip-Flops 1 ist über einen zweiten Inverter 6 mit dem Gate des zweiten P-Kanal MOS-FET 8 verbunden, sowie direkt mit dem Gate des in der Brücke überkreuz angeordneten dritten N-Kanal MOS-FET 9 verbunden. Die MOS-FET 7, 8, 9, 10 werden somit paarweise überkreuz (7 und 10 beziehungsweise 8 und 9) vom Flip-Flop 1 durchgeschaltet.

Liegt am nicht invertierenden Ausgang 1a des Flip-Flops 1 die Ausgangsspannung an, sind der erste MOS-FET 7 sowie der vierte MOS-FET 10 durchgeschaltet. Es kann somit ein Strom von links nach rechts durch im Querzweig der Brücke, das heißt durch den Vorwiderstand 11 und die Induktivität 3 fließen.

Schaltet das Flip-Flop 1 um, liegt am invertierenden Ausgang 1b des Flip-Flops 1 die Ausgangsspannung an. Hierdurch sperren der erste MOS-FET 7 und der vierte MOS-FET 10, wohingegen der zweite MOS-FET 8 und der dritte MOS-FET 9 durchgeschaltet sind.

Durch die durch die Speicherwirkung der Induktivität 3 hervorgerufene Aufrechterhaltung des Stromflusses in Figur 2 von links nach rechts durch den Querzweig der Brücke fällt die Spannung am Signaleingang 2a des Inverters 2 unter den Wert der am Referenzeingang 2b des Komparators 2 liegenden Referenzspannung U_{ref}. Hierdurch wird das Ausgangssignal des Komparators Null.

Nachdem, hervorgerufen durch die Durchschaltung des zweiten MOS-FET 8 und des dritten MOS-FET 9, sich die Stromrichtung im Querzweig der Brücke umgekehrt hat, das heißt, der Strom nun von rechts nach links durch den Querzweig der Brücke fließt, das heißt, durch die Induktivität 3 und den Vorwiderstand 11, steigt der am Schaltschwellenwiderstand 4 hervorgerufene Spannungsabfall wieder an. Nachdem er die Schaltschwelle des Komparators 2 erreicht hat, liegt am Ausgang des Komparators 2 wieder die Ausgangsspannung an. Durch die beim Umschalten des Komparators 2 hervorgerufene Flanke wird das Flip-Flop 1 getriggert, so daß es erneut umschaltet. Der vorher beschriebene Schaltzyklus beginnt somit wieder von vorne.

Der Komparator 2 ist beispielsweise ein Analog-Komparator, der an seinem Ausgang ein Digitalsignal liefert, das in der nachgeschalteten Digitalschaltung einfach verarbeitet werden kann. Als Komparator 2 kann beispielsweise auch ein als Digitalgatter ausgestaltetes Bauteil eingesetzt werden, gegebenenfalls mit einer entsprechend angepaßten Schaltungsauslegung.

Bei der in Figur 2 dargestellten Schaltungsanordnung eines Kompensationsstromsensors ist eine Feldsonde 12 im Luftspalt eines Ringkerns 13 angeordnet, welcher einen Leiter 15 umschließt, dessen Strom gemessen werden soll. Die Feldsonde 12 ist als Induktivität ausgebildet, welche durch das Magnetfeld im Luftspalt des Ringkerns 13 in die Sättigung gelangt. Die Feldsonde 12 stellt die in der Figur 1 enthaltene Induktivität 3 dar und ist in einer Schaltungsanordnung entsprechend Figur 1 angeordnet, welche Teil einer Steuerung 16 bildet. Das durch das im Luftspalt des Ringkerns 13 vorhandene Magnetfeld hervorgerufene Tastverhältnis der durch die Schaltungsanordnung nach Figur 1 erzeugten Rechteckimpulse wird in der Steuerung 16 ausgewertet und zur Erzeugung eines Kompensationsstromes I_{A} verwendet. Der Kompensationsstrom I_{A} wird durch eine Spule 14 geleitet, welche um den Ringkern 13 gewickelt ist.

Die Steuerung 16 ist so ausgelegt, daß der durch die Spule 14 fließende Strom so groß ist, daß das Magnetfeld im Luftspalt des Ringkerns 13 nahezu Null ist. Hierdurch kann der durch die Spule 14 fließende Strom I_{A} als Maß für den durch den Leiter 15 fließenden Strom genommen werden. Zur Erzeugung einer Ausgangsspannung U_{A} ist in Reihe zur Spule 14 ein Widerstand 17 geschaltet, an dem die Ausgangsspannung U_{A} abfällt.

In Figur 3 ist die in der Beschreibungseinleitung gewürdigte bekannte Schaltungsanordnung dargestellt. Wie Figur 3 entnommen werden kann, ist zwischen den Ausgängen eines flankengetriggerten Flip-Flops 21 eine Induktivität 25 geschaltet. Je nach Stellung des Flip-Flops 21 fließt somit Strom in unterschiedliche Richtung durch die Induktivität 25. Zwischen den Ausgängen des Flip-Flops 21 und der Induktivität 25 sind jeweils ein Schaltschwellenwiderstand 26, 27 geschaltet. Die Verbindungsstelle der Schaltschwellenwiderstände 26, 27 sind jeweils mit dem Signaleingang eines Komparators 23, 24 verbunden. Die beiden Referenzeingänge der Komparatoren 23, 24 sind miteinander verbunden, so daß an beiden Komparatoren dieselbe Referenzspannung anliegt. Die Ausgänge der Komparatoren 23, 24 sind mit den beiden Eingängen eines UND-Gatters 22 verbunden. Die Ausgangsignale dieser Komparatoren beeinflussen dabei die Schaltzustände des UND-Gatters. Der Ausgang des UND-Gatters 22 ist mit dem Triggereingang des Flip-Flops 21 verbunden.

Zur weiteren Funktionsweise der in Figur 3 dargestellten bekannten Schaltung wird auf die Beschreibungseinleitung verwiesen.

## Patentansprüche

1. Schaltungsanordnung zur Erzeugung von Rechteckimpulsen, mit einem flankengetriggerten Flip-Flop (1) und wenigstens einem Komparator (2), dessen Ausgang mit dem Triggereingang des Flip-Flops (1) verbunden ist, sowie einem Energiespeicherelement (3), welches in Abhängigkeit des Schaltzustandes des Flip-Flops (1) wechselseitig aufgeladen wird, wobei in Reihe mit dem Energiespeicherelement (3) wenigstens ein Schaltschwellenwiderstand (4) geschaltet ist, an welchem eine vom durch das Energiespeicherelement (3) fließenden Strom erzeugte Spannung abfällt, welche auf den Signaleingang des Komparators (2) gegeben wird, **dadurch gekennzeichnet, daß** das Energiespeicherelement (3) im Querzweig einer Brücke angeordnet ist, in deren vier Brückenabschnitten jeweils ein Schalter (7, 8, 9, 10) angeordnet ist, wobei die Schalter (7, 8, 9, 10) jeweils paarweise überkreuz (7, 10 beziehungsweise 8, 9) von dem Flip-Flop (1) geschaltet werden, so daß der Stromfluß im Querzweig umkehrbar ist, und daß die Brücke mit dem Schaltschwellenwiderstand (4) in Reihe geschaltet ist, wobei die Verbindungsstelle der Brücke mit dem Schaltschwellenwiderstand (4) mit dem Signaleingang (2a) des Komparators (2) verbunden ist.

2. Schaltungsanordnung nach Anspruch 1, **dadurch gekennzeichnet, daß** das Energiespeicherelement (3) eine Induktivität ist.

3. Schaltungsanordnung nach Anspruch 2, **dadurch gekennzeichnet, daß** die Induktivität (3) eine Magnetfeldsonde (12) ist.

4. Schaltungsanordnung nach Anspruch 3, **dadurch gekennzeichnet, daß** die Magnetfeldsonde (12) zur Erfassung des Magnetfeldes eines Kerns (13) eines Kompensationsstromsensors dient.

5. Schaltungsanordnung nach einem der Ansprüche 1 bis 4, **dadurch gekennzeichnet, dass** der Komparator (2) ein Analog-Komparator ist, der als Ausgangssignale Digitalsignale liefert.

6. Schaltungsanordnung nach einem der Ansprüche 1 bis 4, **dadurch gekennzeichnet, daß** der Komparator (2) als Digital-Gatter ausgebildet ist.

7. Schaltungsanordnung nach einem der Ansprüche 1 bis 6, **dadurch gekennzeichnet, daß** die Schalter (7, 8, 9, 10) MOS-FET sind, von denen zwei (9, 10) direkt und zwei (7, 8) über Inverter (5, 6) von den Ausgängen (1a, 1b) des Flip-Flops (1) angesteuert werden.

8. Schaltungsanordnung nach einem der Ansprüche 1 bis 7, **dadurch gekennzeichnet, daß** im Querzweig der Brücke in Reihe mit dem Energiespeicherelement (3) ein Vorwiderstand (11) geschaltet ist.

## Claims

1. Circuit configuration for generating square-wave pulses, having an edge-triggered flip-flop (1) and at least one comparator (2), the output of which is connected to the trigger input of the flip-flop (1), and also an energy storage element (3), which is reciprocally charged in a manner dependent on the switching state of the flip-flop (1), at least one switching threshold resistor (4) being connected in series with the energy storage element (3), a voltage generated by the current flowing through the energy storage element (3) being dropped across the said resistor, which voltage is passed to the signal input of the comparator (2), **characterized in that** the energy storage element (3) is arranged in the shunt path of a bridge in whose four bridge sections a switch (7, 8, 9, 10) is respectively arranged, the switches (7, 8, 9, 10) in each case being switched in pairs crosswise (7, 10 and 8, 9, respectively) by the flip-flop (1), so that the current flow in the shunt path can be reversed, and **in that** the bridge is connected in series with the switching threshold resistor (4), the junction point between the bridge and the switching threshold resistor (4) being connected to the signal input (2a) of the comparator (2).

2. Circuit configuration according to Claim 1, **characterized in that** the energy storage element (3) is an inductance.

3. Circuit configuration according to Claim 2, **characterized in that** the inductance (3) is a magnetic field probe (12).

4. Circuit configuration according to Claim 3, **characterized in that** the magnetic field probe (12) serves for detecting the magnetic field of a core (13) of a compensation current sensor.

5. Circuit configuration according to one of Claims 1 to 4, **characterized in that** the comparator (2) is an analogue comparator that supplies digital signals as output signals.

6. Circuit configuration according to one of Claims 1 to 4, **characterized in that** the comparator (2) is designed as a digital gate.

7. Circuit configuration according to one of Claims 1 to 6, **characterized in that** the switches (7, 8, 9, 10) are MOS-FETs, of which two (9, 10) are driven by the outputs (1a, 1b) of the flip-flop (1) directly and two (7, 8) are driven by the said outputs via inverters (5, 6).

8. Circuit configuration according to one of Claims 1 to 7, **characterized in that** a series resistor (11) is connected in series with the energy storage element (3) in the shunt path of the bridge.

## Revendications

1. Circuit générateur d'impulsions carrées comportant un flip-flop (1) déclenché par un flanc et au moins un comparateur (2) dont la sortie est reliée à l'entrée de déclenchement du flip-flop (1) ainsi qu'un élément accumulateur d'énergie (3) qui se charge alternativement suivant l'état du flip-flop (1),
au moins une résistance de seuil de commutation (4) étant branchée en série sur l'élément accumulateur d'énergie (3), cette résistance fournissant une chute de tension par le courant traversant l'élément accumulateur (3), chute de tension appliquée à l'entrée de signal du comparateur (2),
**caractérisé en ce que**
l'élément accumulateur (3) est installé dans la branche transversale d'un pont dont les quatre segments comportent chacun un commutateur (7, 8, 9, 10),
les commutateurs (7, 8, 9, 10) étant chaque fois commutés par paires croisées (7, 10 ou 8, 9) par le flip-flop (1) pour que le courant traversant la branche transversale soit inversé et
le pont est branché en série sur la résistance de seuil de commutation (4),
le point de liaison du pont à la résistance de seuil de commutation (4) étant relié à l'entrée de signal (2a) du comparateur (2).

2. Circuit générateur d'impulsions carrées selon la revendication 1,
**caractérisé en ce que**
l'élément accumulateur d'énergie (3) est une inductance.

3. Circuit générateur d'impulsions carrées selon la revendication 2,
**caractérisé en ce que**
l'inductance (3) est une sonde de champ magnétique (12).

4. Circuit générateur d'impulsions carrées selon la revendication 3,
**caractérisé en ce que**
la sonde de champ magnétique (12) sert à la saisie du champ magnétique d'un noyau (13) de capteur de courant à compensation.

5. Circuit générateur d'impulsions carrées selon l'une des revendications 1 à 4,
**caractérisé en ce que**
le comparateur (2) est un comparateur analogique fournissant comme signaux de sortie des signaux numériques.

6. Circuit générateur d'impulsions carrées selon l'une des revendications 1 à 4,
**caractérisé en ce que**
le comparateur (2) est une porte numérique.

7. Circuit générateur d'impulsions carrées selon l'une des revendications 1 à 6,
**caractérisé en ce que**
les commutateurs (7, 8, 9, 10) sont des composants MOS-FET dont deux composants (9, 10) sont commandés directement par les sorties (la, 1b) du flip-flop (1) et dont deux composants (7, 8) sont commandés par des inverseurs (5, 6) à partir des sorties du flip-flop.

8. Circuit générateur d'impulsions carrées selon l'une des revendications 1 à 7,
**caractérisé par**
une résistance intermédiaire (11) installée en série avec l'élément accumulateur d'énergie (3) dans la branche transversale du pont.
